# EUROPÄISCHE PATENTSCHRIFT

(11) **EP 2 945 083 B1**
(45) Veröffentlichungstag und Bekanntmachung des Hinweises auf die Patenterteilung: **07.04.2021**
(21) Anmeldenummer: 15165320.1
(22) Anmeldetag: 28.04.2015
(51) Int. Cl.: G06F 30/34

(54) **VERFAHREN ZUR AUTOMATISIERTEN ERSTELLUNG EINER NETZLISTE EINES FPGA-PROGRAMMS**
METHOD FOR THE AUTOMATIC CREATION OF A NETWORK LIST OF A FPGA PROGRAM
PROCÉDÉ DE FABRICATION AUTOMATIQUE D'UNE LISTE DE RÉSEAU D'UN PROGRAMME FPGA

(30) Priorität: 13.05.2014 EP 14168015
(43) Veröffentlichungstag der Anmeldung: 18.11.2015
(73) Patentinhaber: dSPACE digital signal processing and control engineering GmbH, 33102 Paderborn (DE)
(72) Erfinder: Kalte, Heiko, 33106 Paderborn (DE); Lubeley, Dominik, 33415 Verl (DE)

(56) Entgegenhaltungen:
- WO-A1-2004/045106
- WO-A2-01/45258
- US-B1- 7 464 362
- US-B1- 8 407 645
- "Vivado Design Suite Tutorial: Hierarchical Design", , 30. Oktober 2013 (2013-10-30), Seiten 1-25, XP055136447, Gefunden im Internet: URL:http://www.xilinx.com/support/document ation/sw_manuals/xilinx2013_3/ug946-vivado -hierarchical-design-tutorial.pdf [gefunden am 2014-08-26]
- Anonymous: "Visual Studio SDK - Handle File Save Event - Stack Overflow", , 23 March 2012 (2012-03-23), XP055311665, Retrieved from the Internet: URL:http://stackoverflow.com/questions/984 4900/visual-studio-sdk-handle-file-save-ev ent [retrieved on 2016-10-18]
- Anonymous: "dp_connect", , 17 June 2006 (2006-06-17), XP055311672, Retrieved from the Internet: URL:https://web.archive.org/web/2006061710 0104/http://www.cs.cornell.edu/Info/Projec ts/zeno/Tcl-DP/html/dp_connect.html [retrieved on 2016-10-18]
- Anonymous: "Jenkins users - Build on a specific date/time trigger", , 16 September 2010 (2010-09-16), XP055311678, Retrieved from the Internet: URL:http://jenkins-ci.361315.n4.nabble.com /Build-on-a-specific-date-time-trigger-td2 542845.html [retrieved on 2016-10-18]
- Mohammad Tehranipoor: "CAD Algorithms Partitioning", , 13 October 2008 (2008-10-13), pages 1-22, XP055358914, Retrieved from the Internet: URL:http://www.engr.uconn.edu/~tehrani/tea ching/cad/13_partitioning.pdf [retrieved on 2017-03-27]
- Xilinx Coorperation: "Vivado Design Suite User Guide Implementation", , 18 December 2012 (2012-12-18), XP055383554, Retrieved from the Internet: URL:https://www.xilinx.com/support/documen tation/sw_manuals/xilinx2012_4/ug904-vivad o-implementation.pdf [retrieved on 2017-06-21]
- Jim Wu: "Version control for Vivado Design Suite (FPGA modules version control)", , 5 August 2013 (2013-08-05), XP055286565, Retrieved from the Internet: URL:http://www.xilinx.com/support/document ation/application_notes/xapp1165.pdf [retrieved on 2016-07-07]

## Beschreibung

Im Stand der Technik wird ein FPGA-Programm in einer abstrahierenden Entwicklungsumgebung erstellt. Dies ermöglicht den Nutzern auch ohne detaillierte Kenntnisse über FPGAs und Toolflows, ein FPGA-Programm zu entwickeln. Ein Beispiel für eine solche Entwicklungsumgebung stellt beispielsweise das Programm "Simulink" der Firma The Mathworks in Verbindung mit dem Programm "System Generator for DSP" der Firma Xilinx dar. In einer solchen Entwicklungsumgebung wird ein Modell des FPGA-Programms erstellt. Zum Test des erstellten Modells ist ein Build einer Netzliste für die Konfiguration eines FPGA aus dem Modell des FPGA-Programm notwendig. Typischerweise umfasst ein FPGA Build die Schritte Synthese, Platzieren und Routen. Aus der so vorbereiteten Netzliste wird dann ein Bitstrom für die Konfiguration des FPGAs erzeugt. Der Prozess des Builds dauert jedoch vergleichsweise lange, sodass sich bei häufigen Änderungen am Modell des FPGA-Programms große Wartezeiten ergeben.

Um die Zeit zu verkürzen, bis nach dem Abschluss der Modellierung eine komplette platzierte und geroutete Netzliste bereit steht, ist es bekannt, das Modell manuell in Komponenten aufzuteilen, einen FPGA manuell zu partitionieren, die Komponenten jeweils einzeln zu synthetisieren und passend für eine Partition zu platzieren und zu routen. Während des vollständigen Builds für das gesamte Modell werden die bereits platzierten und gerouteten Netzlisten der Komponenten einfach unangetastet übernommen und bei Bedarf die Verbindungen zwischen den Komponenten erstellt. Diese Vorgehensweise lässt sich mit dem von Xilinx als "Hierarchical Toolflow" benannten Toolflow realisieren. Das Partitionieren eines FPGA wird auch als Floorplanning bezeichnet.

US8407645B1 offenbart das Aufteilen eines Modells und das separate Builden einzelner Komponenten.

Das Dokument WO01/45258A2 beschreibt wie aus einem Modell, das mehrere Macros für einen Bereich hat, wobei jeweils nur ein Macro aktiv ist, mehrere Bitströme für partielle Rekonfiguration erstellt werden.

Das Dokument US7464362B1 beschreibt die inkrementelle Kompilierung, wobei einzelne Module auch mehrfach kompiliert werden können.

Aus dem Dokument "Vivado Design Suite Tutorial: Hierarchical Design" ist bekannt, dass einzelne Module losgelöst vom Rest des Modells (out-of-context) kompiliert werden können. Die einzelnen Module werden einer separaten Partition auf dem FPGA zugeordnet. Aus den einzelnen Modulen werden einzelne Netzlisten erzeugt und aus den Netzlisten ein Gesamtstand erzeugt.

Aus "Visual Studio SDK - Handle File Save Event - Stack Overflow", 23. März 2012 (2012-03-23), XP055311665, Gefunden im Internet: URL:http://stackoverflow.com/questions/9844900/visual-studio-sdkhandle-file-save-event [gefunden am 201 6-1 0-18]ist das Triggern durch das Speichern einer Datei bekannt.

Aus dem Dokument WO2004/045106A1 ist das manuelle triggern von events bekannt.

Aus "dp_connect", 17. Juni 2006 (2006-06-17), XP055311672, Gefunden im Internet: URL:https://web.archive.org/web/20060617100104/http://www.cs.cornell.edu/Info/Projects/zeno/T cl-DP/html/dp_connect.html [gefunden am 201 6-1 0-18] ist das Triggern durch das schließen einer Verbindung bekannt.

Aus "Jenkins users - Build on a specific date/time trigger", 16. September 2010 (2010-09-16), XP055311678, Gefunden im Internet: URL:http://jenki ns-ci.361315. n4. nabble.com/Build-on-a-specific-datetime-trigger-td2542845.html [gefunden am 201 6-1 0-18] ist zeitgesteuertes Triggern bekannt.

Aus Mohammad Tehranipoor: "CAD Algorithms Partitioning", 13. Oktober 2008 (2008-10-13), Seiten 1-22, XP055358914, Gefunden im Internet: URL:http://www.engr.uconn.edu/~tehrani/teachirg/cad/13_partitioning.pdf [gefunden am 2017-03-27] ist das Partitionieren von Schaltungen bekannt.

Aus Xilinx Coorperation: "Vivado Design Suite User Guide Implementation", 18. Dezember 2012 (2012-12-18), XP055383554, Gefunden im Internet: URL:https://www.xilinx.com/support/documentation/sw_manuals/xilinx2012_4/ug904-vivado-implementation.pdf [gefunden am 2017-06-21] ist das Wiederverwenden von früheren Platzierung- und Routingergebnissen bekannt.

Aus Jim Wu: "Version control for Vivado Design Suite (FPGA modules version control)", 5. August 2013 (2013-08-05), XP055286565, Gefunden im Internet: URL:http://www.xilinx.com/support/documentation/application_notes/xapp1165.pdf [gefunden am 2016-07-07] ist eine Versionskontrolle von out-of-context Modulen bekannt.

Aufgabe der Erfindung gemäss dem unabhängigen Anspruch 1 ist es, den Stand der Technik weiterzubilden.

Basierend auf dem oben genannten Hierarchical Toolflow sollen stets möglichst aktuelle Netzlisten von Komponenten und FPGA-Gesamtständen für den Nutzer vorgehalten werden. Der im Stand der Technik bekannte vollständige Build, bei dem alle Komponenten immer neu synthetisiert, platziert und geroutet werden, ist nicht effizient und im Rapid Control Prototyping Umfeld nicht praktikabel. Das in dieser Erfindung beschriebene Verfahren verbessert den Hierarchical Toolflow. Das Verfahren macht sich den Hierarchical Toolflow zu Nutze und erweitert ihn um zusätzliche Schritte. Diese Schritte, die einzeln oder in Kombination in diesem Verfahren genutzt werden, sind:
1. **Automatisierter FPGA PreBuild:** Die einzelnen Komponenten werden automatisiert im Hintergrund neu gebuildet, d.h. synthetisiert und ggf. platziert und geroutet, damit sie bei Bedarf direkt einsetzbar sind. Ein Job Queuer erkennt dazu Trigger und initiiert den Build von Komponenten. Gesamtstände, d.h. vollständige Netzlisten des Modells oder auch aus den Netzlisten erzeugte Bitströme zur Konfiguration eines FPGA, werden in einer bevorzugten Variante ebenfalls automatisiert per PreBuild bereitgestellt. Das automatisierte Builden von Komponenten und Gesamtständen wird in einer bevorzugten Variante auf mehrere Prozessorkerne verteilt. Diese Prozessorkerne können sich im gleichen Computer befinden oder über ein Netzwerk verbunden sein.
2. **Automatisierte Versionierung:** Die einzelnen Komponenten werden samt Netzlisten automatisiert versioniert, so dass bei einem Wechsel zu einer alten KomponentenVersion fertige Netzlisten der Komponente zur Verfügung stehen. Der Versionswechsel wird implizit erkannt, indem aktuelle Komponentenversionen mit bereits versionierten Ständen verglichen werden.
3. **Automatisierte Modularisierung:** Zu flache Modell-/Code-Hierarchien werden automatisiert in kleinere Komponenten unterteilt. Kleinere Komponenten lassen sich im Allgemeinen schneller builden und leichter austauschen.
4. **Automatisiertes Floorplanning:** Für die Komponenten werden automatisiert nach verschiedenen Kriterien, wie bspw. dem Ressourcenbedarf der Komponenten oder dem Datenaustausch der Komponenten untereinander, Bereiche im FPGA für die Implementierung reserviert. Für Komponenten, zwischen denen kein direkter Datenaustausch stattfindet, können bspw. räumlich voneinander entfernte Bereiche des FPGAs reserviert werden.
5. **Nutzung eines bereits existierenden Gesamtstandes,** um bei einer Änderung an einer Komponente diese in dem existierenden Gesamtstand zu aktualisieren. Auf diese Weise kommt man schnell zu einem neuen Gesamtstand mit der geänderten Komponente.
6. **Erweiterter FPGA Build Job Queuer:** FPGA Build Jobs werden an einen erweiterten Job Queuer übergeben. Dieser verteilt Jobs auf verschiedene ihm zur Verfügung stehende Ressourcen, wie z.B. freie Kerne, eine Build Farm oder Build Cloud. Gegenüber normalen Job Queuern kennt der erweiterte Job Queuer nicht nur Prioritäten von Build Jobs, sondern auch deren Abhängigkeiten. Durch permanente Überwachung, Ressourcenvergabe und Ressourcenentzug lässt sich ein aktueller Gesamtstand schneller bereitstellen.

Durch die oben genannten Schritte kann eine vollständige Netzliste des FPGA-Programms wesentlich schneller zur Verfügung gestellt werden. Einzelne Komponenten lassen sich nach dem Baukastenprinzip austauschen und bei Bedarf sogar online per partieller Rekonfiguration in den laufenden FPGA einfügen.

Je mehr parallele Rechenleistung zur Verfügung steht, desto aktueller können Gesamtstände oder Netzlisten einzelner Komponenten noch während der laufenden Modellierung durch den Nutzer vorgehalten werden. Dazu beinhaltet eine Ausgestaltung der Erfindung einen erweiterten Job Queuer, der prioritätsbasiert FPGA Build Jobs für die einzelnen Komponenten und auch für einen Gesamtstand startet. Die Jobs können vom erweiterten Job Queuer auf mehrere Kerne, FPGA Buildfarmen und Clouds priorisiert verteilt werden. Darüber hinaus können die Jobs nachträglich umgewichtet und/oder abgebrochen werden, bspw. wenn eine automatisiert gestartete Synthese unterbrochen werden muss, weil an der Komponente weitere Änderungen durch den Nutzer erfolgt sind.

Die Erfindung betrifft ein Verfahren zur Erstellung einer Netzliste eines FPGA-Programms, wobei das zugrundeliegende Modell des FPGA-Programms aus mindestens zwei Komponenten besteht, wobei jeder Komponente eine separate Partition auf dem FPGA zugeordnet wird, wobei für jede Komponente ein eigenständiger Build einer Netzliste durchgeführt wird und die Build Jobs automatisiert von einem Job Queuer nach einem Trigger gestartet werden, wobei aus den Netzlisten der Komponenten ein Gesamtstand erzeugt wird, wobei die Build Jobs automatisiert nach einem Triggerereignis gestartet werden, wobei das Triggerereignis ein Abspeichern einer Komponente, das Verlassen einer Komponente des Modells oder ein zeitgesteuertes, automatisiertes Anstoßen eines Builds ist.

Ein Vorteil der Erfindung ist, dass Netzlisten von Komponenten und Gesamtstände schneller vorgehalten werden können, da nicht gewartet wird, bis der Nutzer den Build von Komponenten und Gesamtständen anstößt. Stattdessen wird während der Erstellung bzw. Modifizierung des Modells durch den Nutzer automatisiert ein Build angestoßen. So kann bspw. nach dem Speichern einer Komponente für diese Komponente automatisiert ein Build angestoßen werden oder, wenn der Nutzer in der Modellierungsumgebung eine Komponente verlässt, also bspw. ein Editierfenster schließt, für diese Komponente automatisiert ein Build angestoßen werden. Ein Gesamtstand stellt eine platzierte und geroutete Netzliste des kompletten FPGA-Modells dar. Aus einem Gesamtstand kann ein Bitstrom für die Konfiguration eines FPGAs erstellt werden.

Gemäß der Erfindung werden die Netzlisten der Komponenten automatisiert versioniert.

Ein Vorteil der Versionierung ist es, dass bei einem Wechsel zu einer alten KomponentenVersion fertige Netzlisten der Komponente erkannt und genutzt werden können. Die Netzlisten können hierbei unplatzierte Netzlisten, platzierte Netzlisten oder geroutete Netzlisten sein.

Gemäß der Erfindung wird das Modell des FPGA-Programms automatisiert in eine Vielzahl von Komponenten unterteilt.

Ein Vorteil der automatisierten Unterteilung ist es, dass der Nutzer von dieser Aufgabe entbunden wird und die Komponenten unabhängig voneinander und parallel gebuildet werden können. Durch die Unabhängigkeit kann eine Komponente bereits gebuildet werden, während der Nutzer an einer anderen Komponente Änderungen vornimmt. Durch die Parallelität können Build Jobs gleichzeitig auf unterschiedlichen Build Ressourcen durchgeführt werden.

Für ein Modell, das aus mehreren Submodellen besteht, kann die automatisierte Aufteilung in der Nutzung der Submodelle als Komponenten bestehen. Ebenso können Submodelle, die aus mehreren Subsubmodellen bestehen, in diese aufgeteilt werden, um mehr und kleinere Komponenten zu erhalten. Die Nutzung der Aufteilung des Modells in Submodelle als Grundlage für die Aufteilung ermöglicht sehr einfach eine Automatisierung der Aufteilung. Ein anderer Ansatz ist die Abbildung des Modells auf einen Graphen bzw. Hypergraphen. Eine solche Abbildung ist bspw. möglich, wenn das Modell als Netzliste vorliegt. Dann werden die Logikzellen der Netzliste auf die Knoten des Graphen und die Verbindungen auf die Kanten des Graphen abgebildet. Nach der Abbildung können Algorithmen für die Aufteilung von Graphen bzw. Hypergraphen genutzt werden. Bei einem graphischen Modell können die Blöcke auf die Knoten und die Verbindungen auf die Kanten abgebildet werden. Generell kann ein Modell an beliebigen Grenzen in Komponenten aufgeteilt werden. So können grafische Modelle an Verbindungen zwischen Blöcken aufgetrennt werden oder VHDL-Modelle in Gruppen von Entitäten oder in einzelne Entitäten aufgeteilt werden. Eine Aufteilung in mehr und kleinere Komponenten erhöht die mögliche Parallelität der Build-Jobs, vermindert im Gegenzug allerdings die Möglichkeiten der übergreifenden Optimierung, da jede Komponente nur in sich optimiert werden kann.

In einer vorteilhaften Ausgestaltung der Erfindung wird das FPGA automatisiert in eine Anzahl von Partitionen aufgeteilt, die der Anzahl der Komponenten des Modells des FPGA-Programms entspricht und in der die Komponenten automatisiert den Partitionen zugewiesen werden.

Ein Vorteil der automatisierten Aufteilung des FPGAs und der automatisierten Zuweisung der Komponenten zu den Partitionen ist es, dass die Partitionierung und Zuweisung jederzeit automatisiert wiederholt und dabei geändert werden kann. Bei Änderungen an den Komponenten, durch welche der Ressourcenbedarf der Netzliste den Ressourcenvorrat der zugewiesenen Partition übersteigt, wird so automatisiert durch eine neue Partitionierung der Floorplan angepasst und damit ein automatisierter Build ermöglicht.

In einer vorteilhaften Ausgestaltung der Erfindung wird eine erste Partition verkleinert und ein von der gebuildeten Form der Komponente, die der ersten Partition zugewiesenen ist, nicht benötigter Anteil einer zweiten Partition zugeordnet.

Ein Vorteil der Verkleinerung ist es, dass Partitionen möglichst wenig ungenutzten Bereich reservieren. Wenn nach dem Build die von der Komponente genutzten Bereiche feststehen, können ungenutzte Bereiche anderen Partitionen zugeordnet werden.

In einer vorteilhaften Ausgestaltung der Erfindung werden eine dritte Partition und eine vierte Partition zu einer fünften Partition zusammengelegt und die der dritten Partition und der vierten Partition zugeordneten Komponenten zusammengefügt.

Ein Vorteil der Zusammenlegung ist es, dass den Werkzeugen, die aus den Modellkomponenten den Konfigurationsbitstrom erzeugen, mehr Möglichkeiten der Optimierung offen stehen, wenn die Modellkomponenten nicht in Subkomponenten aufgeteilt sind. Durch die Zusammenlegung kann also eine höher optimierte Konfiguration erreicht werden, d.h. das Programm kann auf dem FPGA schneller abgearbeitet werden, bspw. da der FPGA mit einem höheren Takt betrieben werden kann, und/oder es werden für das Programm weniger Elemente des FPGAs benötigt.

Gemäß der Erfindung wird automatisiert ein Gesamtstand gebuildet, sobald Netzlisten aller Komponenten des Modells in einer gerouteten Form vorliegen.

Ein Vorteil des automatisierten Buildens eines Gesamtstandes ist es, dass ein Gesamtstand frühzeitig vorliegt, und dass der Gesamtstand bei Änderungen an Komponenten in vielen Fällen zu großen Teilen weiterverwendet werden kann.

Gemäß der Erfindung wird, wenn bereits ein Gesamtstand vorliegt, bei einer Änderung an einer Komponente, beim Build eines neuen Gesamtstandes die geänderte Komponente im Gesamtstand aktualisiert.

Ein Vorteil, nur die geänderten Komponenten eines existierenden Gesamtstandes zu aktualisieren ist es, dass es für die Build Tools wesentlich weniger Zeit in Anspruch nimmt, Komponenten in einen Gesamtstand zu aktualisieren, als einen Gesamtstand aus dem Gesamtmodell/Gesamtquellcode zu erzeugen.

In einer vorteilhaften Ausgestaltung der Erfindung werden die fertig gebuildeten Gesamtstände automatisiert versioniert.

Ein Vorteil der Versionierung ist es, dass bei einem Wechsel zu einer alten Version des Modells ein zu der Version gehörender fertiger Gesamtstand erkannt und genutzt werden kann.

In einer vorteilhaften Ausgestaltung der Erfindung werden die Build Jobs von einem erweiterten Job Queuer verwaltet.

Ein Vorteil des erweiterten Job Queuers ist es, dass er prioritätsbasiert FPGA Build Jobs für die einzelnen Komponenten und auch für einen Gesamtstand startet. Die Jobs können vom erweiterten Job Queuer auf mehrere Kerne, FPGA Buildfarmen und Clouds priorisiert verteilt werden. Darüber hinaus können die Jobs nachträglich umgewichtet und/oder abgebrochen werden, bspw. wenn eine automatisiert gestartete Synthese unterbrochen werden muss, weil an der Komponente weitere Änderungen durch den Nutzer erfolgt sind.

Die Erfindung betrifft ferner eine Entwicklungsumgebung für ein FPGA-Programm, die ein erfindungsgemäßes Verfahren durchführt.

Im Folgenden werden einzelne Aspekte der Erfindung an Beispielen erläutert. Die verschiedenen Aspekte können alleine oder in Kombination genutzt werden.

### Dabei zeigt

**Figur 1** den Zeitverlauf eines initialen FPGA Build und die qualitative Zeitersparnis bei einer Änderung an einer Komponente,
**Figur 2** zwei Anwendungsfälle des erfindungsgemäßen Verfahrens,
**Figur 3** ein Übersichts-Ablaufdiagramm der Erfindung,
**Figur 4** eine Modularisierung eine Modells eines FPGA-Programms in Komponenten und Reservierung von Flächen für diese Komponenten in Form eines Floorplans im FPGA,
**Figur 5** den Rebuild einer einzelnen Komponente mit optionaler Vergrößerung,
**Figur 6** den Rebuild einer einzelnen Komponente mit neuer Platzierung auf dem FPGA,
**Figur 7** den Rebuild einer einzelnen Komponente mit Region Growing,
**Figur 8** das Einfügen einer neuen Komponente,
**Figur 9** einen Design-flow der Erfindung,
**Figur 10** eine kreisbasierte Platzierung des Ausganspunktes von Komponenten mit und ohne Reserven auf dem FPGA,
**Figur 11** eine initiale Platzierung der Komponenten auf dem FPGA als Rechtecke auf den Ausgangspunkten,
**Figur 12** eine initiale Platzierung der Komponenten auf dem FPGA mittels Region Growing.

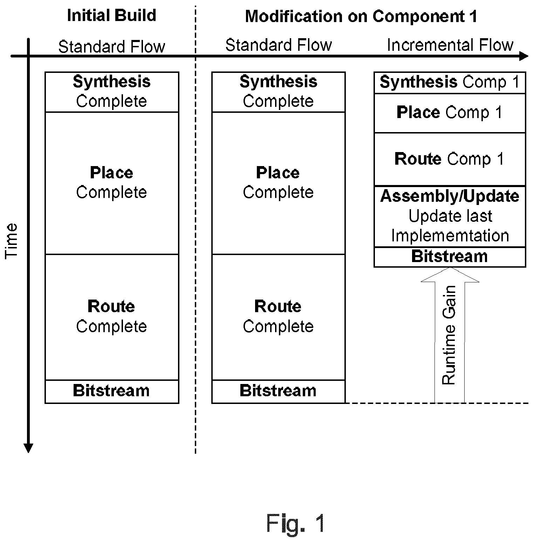

Figur 1 zeigt den Zeitverlauf eines initialen FPGA Builds und die qualitative Zeitersparnis bei einer Änderung an einer Komponente. Auf der linken Seite ist der normale Ablauf eines initialen Builds gezeigt. Im normalen Ablauf wird zuerst eine Synthese des gesamten FPGA Modells vorgenommen. Die synthetisierten Komponenten des Modells werden dann auf die logischen Blöcke des FPGAs platziert. Danach werden die Signalleitungen zwischen den Komponenten verlegt. Aus der Gesamtheit der Komponenten und Signalleitungen wird dann der Bitstrom für die Konfiguration des FPGAs erzeugt. Dieser Ablauf muss nicht bei jeder Änderung am Modell/Quellcode durchlaufen werden. Der normale Ablauf wird lediglich beim ersten Build durchgeführt. Bei Änderungen an einer einzelnen Komponente wird lediglich diese einzelne Komponente erneut synthetisiert, platziert und geroutet, sowie mit den bereits fertigen Netzlisten von Komponenten des FPGA-Programms zusammengefügt. Ein Build des kompletten FPGA-Programms nimmt daher weniger Zeit in Anspruch, da bereits viele Komponenten fertig sind und nicht das gesamte Modell neu synthetisiert, platziert und geroutet wird. Danach wird für das gesamte Modell ein Bitstrom erzeugt.

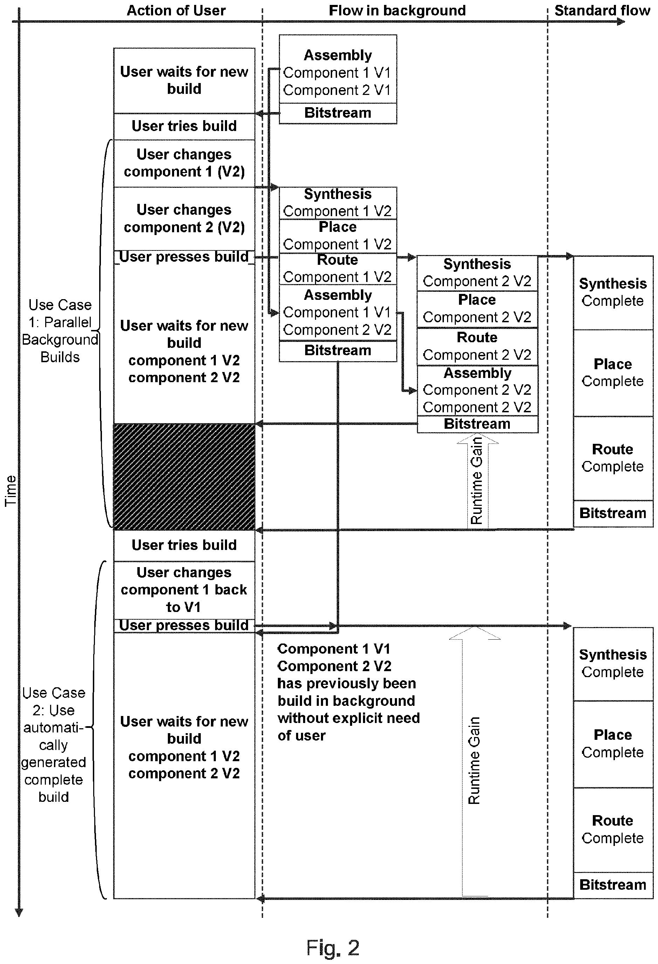

Figur 2 zeigt zwei wesentliche Anwendungsfälle der Erfindung. Zum einen ist dies das automatisierte, parallelisierte Erstellen von Komponentenständen und Gesamtständen, so dass bei einer Build Anforderung des Nutzers sehr zeitnah ein Gesamtstand verfügbar gemacht werden kann (Use Case 1). Zum anderen werden im Hintergrund ständig weitere Kombinationen von Komponentenversionen gebaut, so dass der Kunde z.B. beim Zurückdrehen einer Komponente auf eine alte Version ggf. sofort einen Gesamtstand erhalten kann (Use Case 2), weil dieser ohne sein Wissen bereits existiert.

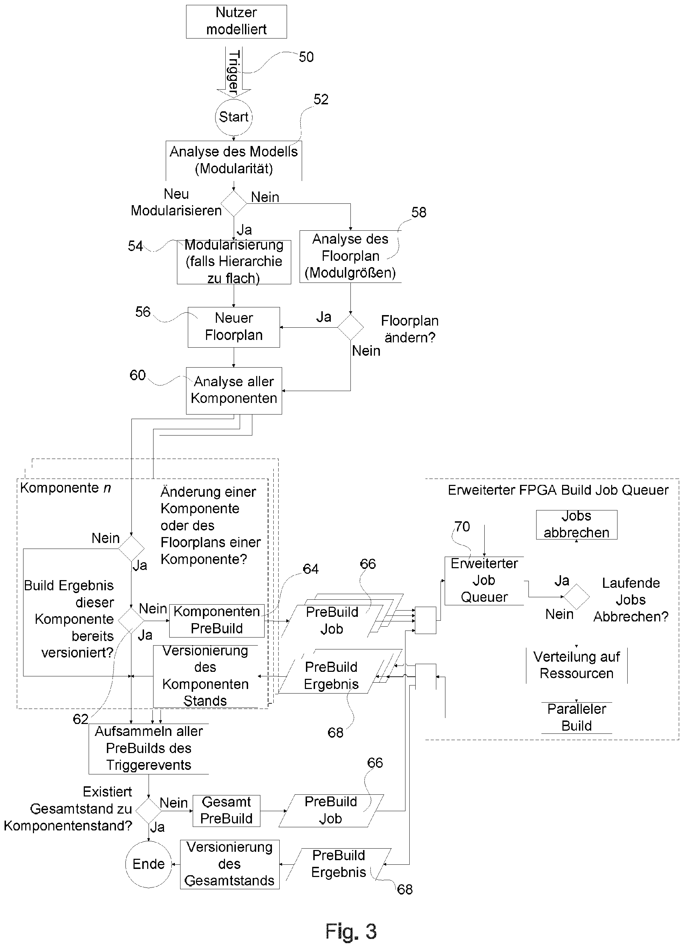

In Figur 3 ist ein Ablaufdiagramm dargestellt. Der Startpunkt ist ein Trigger, während der Nutzer noch modelliert, und das Ergebnis ist ein vollständiger FPGA Gesamtstand. Der Gesamtprozess ist durch den Nutzer an- und abschaltbar, sodass der Nutzer z.B. nach Abschluss der Entwicklungsphase einen normalen, vollständigen Build ohne Floorplanning starten kann.

Gestartet wird der Prozess durch einen Trigger 50, während der Nutzer noch modelliert. Ein Trigger 50 kann z.B. eines der folgenden Ereignisse sein:
- Nutzer speichert sein grafisches Model oder seinen textuellen Quellcode. Ein ggf. erhaltenswerter Stand der Modellierung ist erreicht.
- Der Scope eines Subsystems wird im grafischen Modellierungswerkzeug vom Nutzer verlassen. Somit wird angedeutet, dass dieses Subsystem einen vorerst abgeschlossenen Stand erreicht hat.
- Der Prozess wird nach einer bestimmten Zeit automatisiert angestoßen.
- FPGA Build wird explizit durch den Nutzer angestoßen. Dieser Fall ist aus dem Hierarchical Toolflow bekannt.

Nach dem Trigger 50 wird das Model / der Quellcode zunächst analysiert 52. Das Gesamtdesign des FPGAs muss ggf. in sinnvolle Einzelkomponenten aufgeteilt werden, falls dies noch nicht geschehen ist. Bei dieser Modularisierung 54 sind verschiedene Strategien möglich, z.B. ähnlich große Komponenten zu bilden, damit Änderungen an einer Komponente immer ähnlich lange Buildzeiten verursachen bzw. bei parallelem Build mehrerer Komponenten nicht lange auf eine große Komponente gewartet werden muss, oder sich häufig ändernde Komponenten möglichst klein zu halten, da deren Änderung sich nicht übermäßig nachteilig auf einen neuen Build auswirken. Eine sich häufig ändernde Komponente kann während der Modellierung nicht nur an der Anzahl der tatsächlichen Änderungen erkannt werden, sondern ggf. auch an der Anzahl, wie oft ein Nutzer in ein grafisches Subsystem rein- und rausspringt. Bei einer neuen Modularisierung ist auch ein neuer Floorplan 56 notwendig. Hierbei ist jedoch immer zu bedenken, dass für eine bestimmte Modularisierung und einen dazu passenden Floorplan ggf. bereits implementierte Komponenten existieren, so dass diese bei einer Neu-Modularisierung und damit auch ein Neu-Floorplanning ggf. nicht weiter verwendet werden können. Entsprechende Bewertungsfunktionen sind erforderlich. Bei Änderungen an den Komponenten kann ein neuer Floorplan auch ohne neue Modularisierung notwendig werden, wenn eine Analyse der Komponentengrößen 58 ergibt, dass Komponenten nicht mehr in ihre Partition passen.

Eine Modularisierung und ein Floorplan können auch vom Nutzer vorgegeben sein. Ebenso kann eine neue Modularisierung und ein neues Floorplanning durch den Nutzer unterstützt sein.

Die einzelnen Komponenten werden nun daraufhin analysiert 60, ob es für die aktuelle Version und die zugehörige Partition des Floorplan bereits einen PreBuild gibt. Falls dies nicht der Fall ist, wird ein PreBuild Job vergeben, der vom erweiterten Job Queuer verteilt wird. Sind für alle Komponenten PreBuilds vorhanden, so wird ein Gesamt PreBuild erstellt. Die PreBuild Ergebnisse der einzelnen Komponenten und des Gesamtstandes werden versioniert, damit darauf bei Bedarf zurückgegriffen werden kann.

Grundsätzlich kann das Design in unterschiedlich abstrakter Form vorliegen, wie im Folgenden beschrieben:

### • Grafisches Modell

Das Model liegt möglicherweise bereits in Form grafisch erkennbarer Subsysteme vor, die direkt als Komponenten dienen und nicht weiter unterteilt werden müssen. Falls im grafischen Fall eine zu flache Hierarchie vorgegeben ist, kann im Hintergrund eine automatisiert generierte, modularisierte, konsistente Kopie vorgehalten werden, die als Grundlage für die Versionierung und den PreBuild der Komponenten dient. Alternativ kann aus dem Model erst HDL Code generiert werden und auf dieser Basis eine Modularisierung durchgeführt werden.

### • Quellcodebasierter Ansatz / RTL (Register Transfer Level)

Liegt das Design bereits in einer Hardwarebeschreibungssprache (z.B. VHDL, Verilog) in Form von verschiedenen Komponenten mit definierten Schnittstellen/Entities vor, kann diese Modularisierung beibehalten werden, oder es wird eine für den Ansatz günstigere Umstrukturierung vorgenommen, bspw. wird die Hierarchie flacher oder tiefer gemacht. Auch hierzu kann im Hintergrund eine automatisiert generierte modularisierte konsistente Kopie vorgehalten werden, die als Grundlage für die Versionierung und den PreBuild der Komponenten dient. Die Realisierung kann z.B. durch Aufstellung eines Graphen, bzw. Hypergraphen auf RTL zur Identifikation relevanter Komponenten realisiert werden.

### • Netzlistenbasierter Ansatz

Durch die FPGA Synthese wird die Hardwarebeschreibungssprache zu Netzlisten übersetzt. Liegt das FPGA Model in Form einer Netzliste vor, können u.a. Graphen-, bzw. Hypergraphen-basierte Verfahren angewendet, um das Design zu unterteilen. Die Partitionierung der Graphen erlaubt es automatisiert Komponenten zu identifizieren, die möglichst autonom ohne viele Interconnections zu anderen Komponenten existieren.

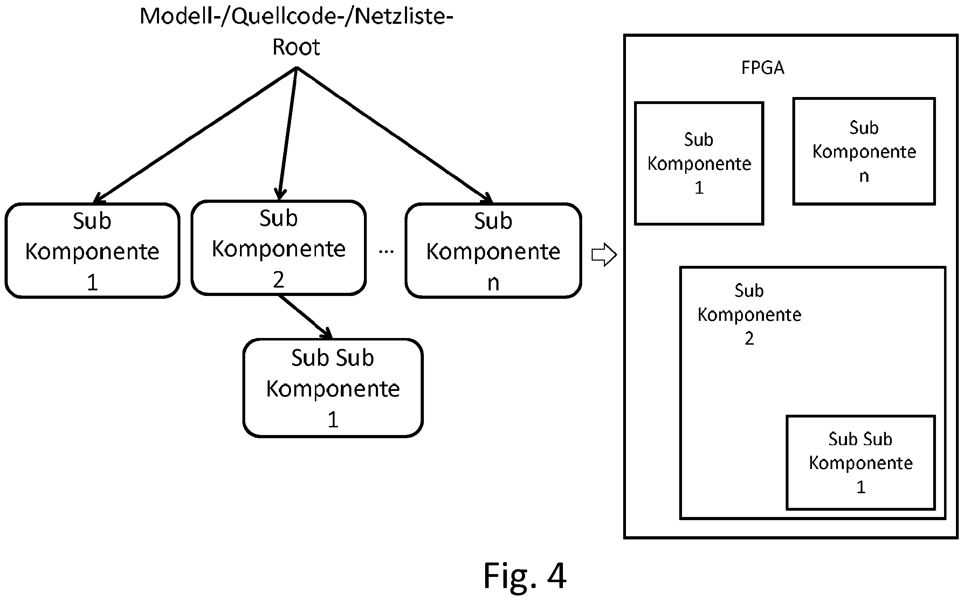

In Figur 4 ist die Modularisierung von Modellen, Quellcode oder Netzlisten in Komponenten exemplarisch dargestellt. Für die einzelnen Komponenten werden über das automatisierte Floorplanning korrespondierende Flächen im FPGA reserviert. Das Modell liegt als grafisches Modell, als Quellcode oder Netzliste vor und unterteilt sich hierarchisch in eine Vielzahl von Subkomponenten, welche evtl. weitere Subsubkomponenten enthalten. Für jede Subkomponente wird eine Fläche im FPGA reserviert.

Die Abschätzung des Ressourcenbedarfs einer Komponente ist die Voraussetzung für das Erstellen eines korrekten Floorplans, ggf. spielt diese auch schon für die Modularisierung eine Rolle. Neben dem eigentlichen Ressourcenbedarf der Komponente können noch andere Parameter die zu reservierende Fläche im FPGA beeinflussen, z.B. wenn eine Komponente manuell oder automatisiert als noch wachsend attributiert ist, wird mehr FPGA Fläche und damit mehr Ressourcen für die Komponente vorgesehen, somit muss nicht gleich ein neuer Floorplan erstellt werden, wenn sich der Ressourcenbedarf einer Komponente vergrößert. Alternativ kann auch für eine sich häufig ändernde Komponente mehr Platz reserviert werden, da hier die Chance groß ist, dass diese auch noch wächst.

Eine Ressourcen-/Flächenabschätzung kann auf verschiedene Arten realisiert werden. Im Folgenden sind einige Möglichkeiten zur Ermittlung des Ressourcenbedarfs aufgeführt:
- Auswertung des Ressourcenbedarfs aus Synthesereports / Syntheseergebnissen. Eine Synthese ist in der Regel schnell abgeschlossen und liefert somit schnelle und realistische Ergebnisse für den Ressourcenbedarf.
- Über Lookuptabellen, die den Ressourcenbedarf einzelner Elemente beziffern, wird der kumulierte Bedarf einer Komponente ermittelt.
- Auswertung des Ressourcenbedarfs von Implementierungsreports / Implementierungsergebnissen. Hierzu können z.B. die Implementierungsergebnisse des letzten Builds einer Komponente verwendet werden, um die zu reservierende Fläche für den nächsten Build zu optimieren. Es können z.B. weniger unnötige Flächenreserven für die Komponente beim Floorplan vorgesehen werden.

Der Ressourcenbedarf einer Komponente ist nicht zwingend proportional zur benötigten Fläche. Im Fall von inhomogener Ressourcenverteilung im FPGA oder speziellem Ressourcenbedarf, z.B. bei starker Nutzung von Elementen wie DSP Slices oder Blockrams, muss berücksichtigt werden, dass die zur Verfügung zu stellende Fläche überproportional größer sein kann als der ausgewiesene Ressourcenbedarf und die benötigten Ressourcen auch enthält.

Nachdem das Nutzerdesign durch Modularisierung 54 in Komponenten unterteilt wurde, ist ein Floorplan 56 zu erstellen. Dazu muss im FPGA eine Fläche gefunden werden, die alle notwendigen Ressourcen der Komponente einschließt und diese muss geeignet auf dem FPGA platziert werden. Dabei wird zwischen der initialen Platzierung, also dem initialen Floorplan, für das ein komplett neuer Floorplan entworfen wird, und dem Replatzieren von Komponenten unterschieden. Bei der Replatzierung wird der bestehende Floorplan nach Möglichkeit in großen Teilen beibehalten, um fertige Komponentenstände weiternutzen zu können. Das Floorplanning kann automatisiert, nutzerunterstützt oder auch manuell durch Nutzereingaben erfolgen.

Für die Erstellung des Floorplans sind Faktoren wie z.B. der Ressourcenbedarf der Komponenten, die Ressourcenverteilung auf dem FPGA und die Beziehung der Komponenten zueinander zu berücksichtigen. Der Ressourcenbedarf und die Beziehungen der einzelnen Komponenten untereinander sind bereits auf RTL und Netzlistenebene bekannt. Die Ressourcenverteilung ist architekturabhängig gegeben.

Eine Platzierung der Komponenten nahe den benötigten Ressourcen ist insbesondere bei heterogener Ressourcenverfügbarkeit anzustreben.

Die initiale Platzierung der Komponenten kann rein zufällig erfolgen. Es ist jedoch vorteilhaft, sie an gewisse Randbedingungen zu knüpfen.

Die Reservierung von Platz für eine Komponente erfolgt in der Regel in rechteckförmigen Teilstücken auf der in der Regel rechteckigen Fläche des FPGAs. Die optimale Verteilung von Rechtecken innerhalb eines Rechtecks ist ein NP-vollständiges Entscheidungsproblem, das unter die Rubrik "2D Bin Packing" fällt. Dieser Ansatz ist für die initiale Platzierung denkbar, er berücksichtigt jedoch noch nicht die Beziehung der Komponenten untereinander und die unter Umständen heterogene Ressourcenverteilung.

Die Anzahl der möglichen Ansätze ist groß. Auf einen kreisbasierten Ansatz, der gut kombinierbar mit einem Region Growing Verfahren ist, wird später eingegangen.

Im Schritt "Analyse des Floorplans" 58 kann es aus verschiedenen Gründen zu einer Anpassung des Floorplans kommen.

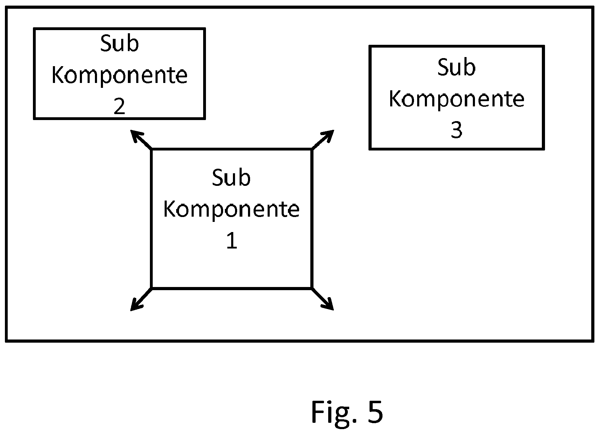

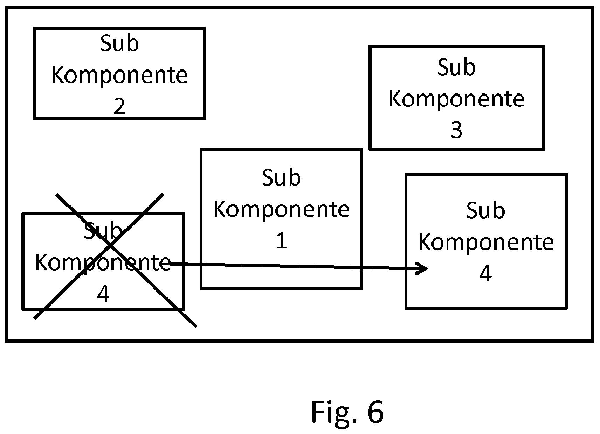

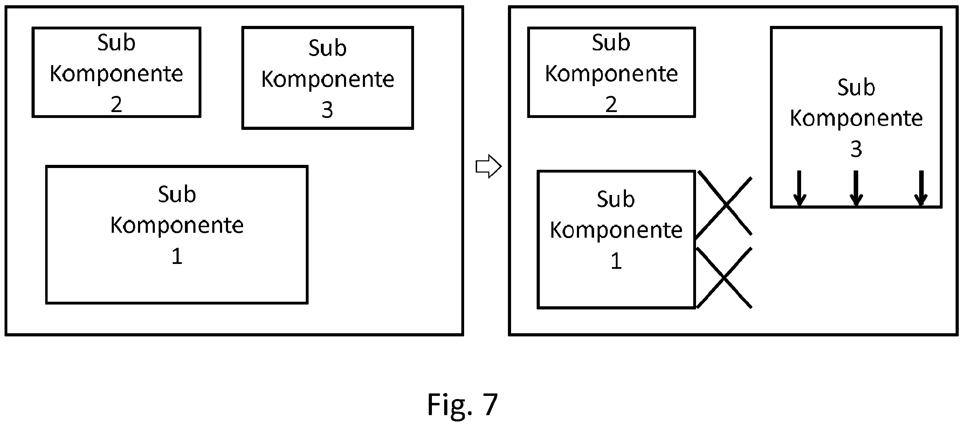

Für die Platzierung bei geändertem Ressourcenbedarf von Komponenten bietet sich z.B. folgendes Verfahren an:
- Rechteckförmige Komponenten
   ∘ Werden in ein oder zwei Dimensionen skaliert und evtl. verschoben und implementiert, um dem neuen Ressourcenbedarf gerecht zu werden. Dies ist in Figur 5 gezeigt.
   ∘ Werden neu dimensioniert, platziert und implementiert, falls der Platzbedarf nicht mehr ausreicht. Dies ist in Figur 6 gezeigt.
   ∘ Falls es auch keine freie Platzierungsmöglichkeit mehr gibt, müssen
      ▪ mehrere Komponenten neu platziert und implementiert
      ▪ alle Komponenten neu initial platziert und implementiert werden
- "Region Growing" Ansatz
   ∘ Wachsen oder Schrumpfen der geänderten Komponenten durch "Region Growing" oder "Region Shrinking". Dies ist in Figur 7 gezeigt.
   ∘ Falls es auch keine freie Platzierungsmöglichkeit mehr gibt, müssen
      ▪ mehrere Komponenten neu platziert und implementiert werden
      ▪ oder alle Komponenten neu initial platziert und implementiert werden

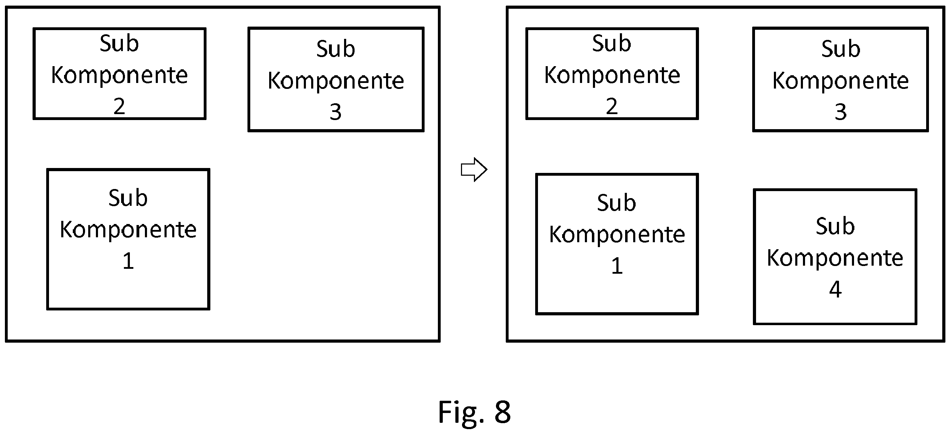

Für die Neuplatzierung einer Komponente:
- Falls es noch genügend freien Platz gibt, wird ein neuer Bereich für die Komponente reserviert. Ein vom Platzierungsverfahren unabhängiges Beispiel ist in Figur 8 gezeigt.
- Falls es keine freie Platzierungsmöglichkeit gibt, müssen
   ∘ mehrere Komponenten neu platziert und implementiert werden
   ∘ alle Komponenten neu initial platziert und implementiert werden

Eine Veränderung der Beziehung von Komponenten zueinander, z.B. durch geänderte Signalconstraints kann zu einer Neuplatzierung von Komponenten führen.

Nach dem Floorplaning erfolgt gemäß dem Übersichtsdiagramm in Figur 3 eine Analyse 60 aller Komponenten. Dabei wird für jede einzelne Komponente kontrolliert, ob sie im aktuellen Floorplan eine andere Position oder Größe erhalten hat. Sollte dies der Fall sein, wird zunächst überprüft, ob bereits ein passender versionierter Stand dieser Komponenten existiert 62 oder ob ein PreBuild der Komponente angestoßen werden muss 64.

Der PreBuild Mechanismus sieht vor, stets PreBuild Jobs 66 für geänderte Komponenten anzustoßen. Zusätzlich zu den PreBuild Jobs 66 werden die einzelnen Komponenten im Hintergrund durch zusätzliche PreBuild Jobs 66 in einen FPGA Gesamtstand eingebunden. Da sich in diesem Gesamtstand immer nur ein kleiner Teilbereich ändert und der Rest gelockt ist, benötigt die Erstellung eines neuen Gesamtstandes deutlich weniger Zeit.

Alle dabei anfallenden Jobs lassen sich effizienter über einen erweiterten FPGA Build Job Queuer 70 verteilen, der unter Umständen Zugriff auf mehrere Prozessorkerne, eine FPGA Build Farm oder eine FPGA Build Cloud hat.

Existieren zu den Komponenten auch Teilbitströme,können diese bei Bedarf zur partiellen Rekonfiguration genutzt werden. So hat der Kunde die Möglichkeit, Teilkomponenten online im laufenden FPGA zu aktualisieren. Verschiedene Stände von Komponenten und die Interaktion verschiedener Komponenten untereinander lassen sich dadurch schnell evaluieren.

Neben einer geänderten Komponentenversion gibt es noch weitere Kriterien, die einen neuen PreBuild bedingen können. Dabei sind u.a. auch die Kriterien Größe, Platzierung und Abstände von Bedeutung.
1. PreBuild, da es noch keinen Build der Komponente gibt
2. PreBuild, da die Komponente einer anderen neuen/gewachsenen Komponente im Weg sein wird und ein neuer Floorplan erstellt wurde.
3. PreBuild für verkleinerte Regionen, da andere Komponente gerade stärker wachsen und ein neuer Floorplan erstellt wurde.
4. PreBuild für eine Komponente für eine neu zugeordnete Fläche im FPGA.
5. PreBuild bei geänderten Constraints, wenn aufgrund von neuen Timingconstraints eine neue Anordnung der Komponenten erforderlich ist.

In einer bevorzugten Ausgestaltung der Erfindung existiert eine automatisierte Versionierung der einzelnen Komponenten und der Gesamtstände. Bei der Analyse aller Komponenten wird festgestellt, ob sich einzelne Komponenten oder deren Floorplan geändert haben. Falls dies der Fall ist, wird als nächstes automatisiert festgestellt, ob der aktuelle Stand der Komponente einem bereits zuvor versionierten Stand entspricht. Dies kann entweder durch direkten Modell-/Quellcode-Vergleich mit allen versionierten Ständen der Komponente oder durch Vergleich z.B. eines Hashwertes einer Komponente erfolgen. Bei dem direkten Vergleich oder z.B. bei der Erstellung eines Hashwertes können irrelevante Bestandteile wie z.B. Kommentare optional ignoriert werden.

Wenn bereits ein versionierter Stand der Komponente vorliegt, so wird dieser verwendet, dadurch wird der aufwendige Buildprozess der Komponente eingespart. Dies ist oft der Fall, wenn der Kunde eine Modifikation an einer Stelle im Modell/Quellcode wieder rückgängig macht.

Liegt noch kein versionierter Stand vor, wird die Komponente mittels eines PreBuild Jobs 66 automatisiert im Hintergrund neu gebuildet. Das Ergebnis des PreBuilds 68 wird anschließend zusammen mit dem Stand der Komponente versioniert abgespeichert.

Eine explizite Auswahl einer Komponentenversion durch den Nutzer, der auf eine alte oder von extern zugestellte Version übergehen möchte, ist ebenfalls möglich.

Stehen nach einem Triggerereignis 50 alle PreBuilds zur Verfügung, wird zunächst überprüft, ob für diese Konstellation von Komponentenständen bereits ein versionierter Gesamtstand existiert. Wenn ja, kann dieser verwendet werden. Falls nicht, wird ein PreBuild Job 66 für den Gesamtstand angestoßen. Hierzu wird ein existierender Gesamtstand verwendet, der dem geforderten am nächsten ist, gibt es bspw. bereits einen Gesamtstand, der 3 von 4 geforderte Komponenten bereits implementiert hat, so muss nur noch eine Komponente aktualisiert werden. Das Ergebnis des PreBuild Jobs 66 liefert den aktuellen Gesamtstand, der zusammen mit den Informationen über die verwendeten Komponentenversionen wieder versioniert wird.

Bei der Versionierung einer Komponente werden alle relevanten Daten der entsprechenden Version zentral oder dezentral abgelegt. Dazu gehört:
- Die komplette Komponente und/oder der Hashwert über die Komponente. Die Nutzung eines Hashwertes spart Platz und Hashwerte sind schneller abgleichbar als komplette Komponenten
- Das Buildergebnis 68 der Komponente
- Datum und Version der Komponente und ggf. weitere Metainformationen

Bei der Versionierung eines Gesamtstandes werden alle relevanten Daten der entsprechenden Version zentral oder dezentral abgelegt. Dazu gehört:
- Information über die verwendeten Komponentenversionen und ggf. auch die kompletten Komponenten in den entsprechenden Versionen
- Das Buildergebnis 68 des Gesamtstandes
- Datum und Version des Gesamtstandes und ggf. weitere Metainformationen

Ein Job Queuer 70 verteilt Build Jobs 66 auf verschiedene ihm zur Verfügung stehende Ressourcen. Dieses können z.B. freie Kerne, eine Build Farm oder auch eine Build Cloud sein. Ebenfalls ist es möglich, dass der Job Queuer 70 eine Priorisierung von Build Jobs 66 vornimmt. Automatisiert angestoßene PreBuild Jobs 66 erhalten in der Regel eine geringere Priorität als vom Nutzer angestoßene Build Jobs. Außerdem kann es Prioritätskriterien geben, in denen PreBuild Jobs auch wieder abgebrochen werden, um Ressourcen für komplette Build Jobs freizugeben.

Der erweiterte FPGA Build Job Queuer 70, wie in Figur 3 dargestellt, hat Aufgaben zu erledigen, die über die eines normalen Job Queuers hinausgehen.

Da die Anzahl der zur Verfügung stehenden Ressourcen stets beschränkt sein wird, kommt es zu einer Konkurrenzsituation unter allen Build Jobs. Durch reine Priorisierung kann diese Situation nicht zufriedenstellend gelöst werden. Aus diesem Grund werden zusätzlich Dependencies zwischen Jobs eingeführt.

In einer vorteilhaften Ausgestaltung der Erfindung werden zusätzlich zu den Prioritäten Abhängigkeiten zwischen den Build Jobs 66 eingeführt.

### Beispiel:

Ein erster Build Job mit niedriger Priorität ist der PreBuild eines bereits veralteten Standes einer Komponente

Ein zweiter Build Job mit niedriger Priorität ist der PreBuild eines aktuellen Standes einer Komponente

Ein dritter Build Job mit hoher Priorität ist der Build eines aktuellen Gesamtstandes

Der dritte Build Job wird in diesem Fall als abhängig vom zweiten Build Job markiert. Obwohl der dritte Build Job eine höhere Priorität als der zweite Build Job hat, wird zuerst gewartet, bis der zweite Build Job abgearbeitet ist, bevor der dritte Build Job gestartet wird. Der erste Build Job kann bei Ressourcenknappheit hingegen abgebrochen werden, da er keine aktuelle Abhängigkeit zum dritten Build Job hat.

Neben der Abhängigkeit wird zusätzlich der Grad der Fertigstellung bewertet; ein zu 90% fertiger Job wird z.B. i.d.R. nicht abgebrochen. Dies ist sinnvoll, da es evtl. ein anderer Komponentenstand ist, den der Nutzer vielleicht auch bald testen will, weil der ganz aktuelle Stand doch nicht funktioniert.

Oftmals werden für den Buildvorgang von hochwertigen großen FPGAs hochwertige FPGA Tools benötigt. Die Verfügbarkeit dieser Ressource ist in der Regel beschränkt. Durch die Aufteilung eines Designs in Teilkomponenten, die geringere Ansprüche an die die Größe und Komplexität des FPGA stellen, lassen sich die PreBuild Jobs auf Ressourcen mit günstigeren FPGA Tools verteilen, die diesen Anforderungen genügen. Somit bleiben die Ressourcen, die in der Lage sind, hochwertige große FPGAs zu builden, für die Zusammenstellung eines kompletten FPGA Gesamtstandes zur Verfügung.

Zusammenfassend hat der erweiterte FPGA Build Job Queuer 70 die Aufgaben:
1. Verteilung von Builds/PreBuilds auf Ressourcen
2. Kontinuierliche Bewertung von Build Jobs unter Beachtung von Build Job Abhängigkeiten und Fertigstellungsgraden.
3. Start und Abbruch von Builds/PreBuilds

Durch die Modularisierung, den automatisierten parallelisierten PreBuild und die Versionierung aller Ergebnisse wird der extrem langwierige Prozess des FPGA Builds auf das Austauschen kleiner Komponenten im FPGA reduziert. Ein aktueller Gesamtstand des sich gerade in der Entwicklung befindlichen Systems kann dadurch schneller erstellt werden.

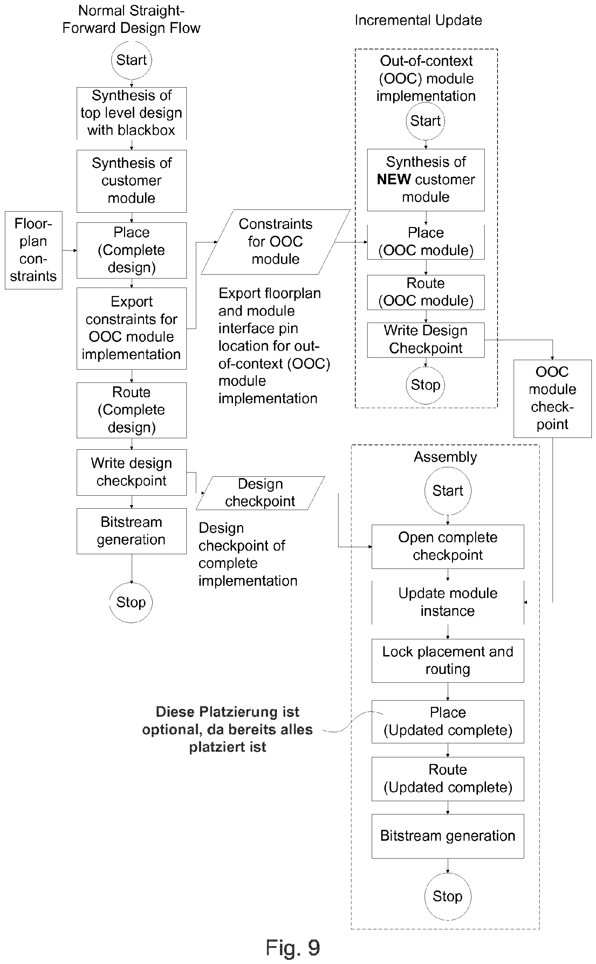

Figur 9 zeigt einen beispielhaften Design-Flow der Erfindung im Detail.

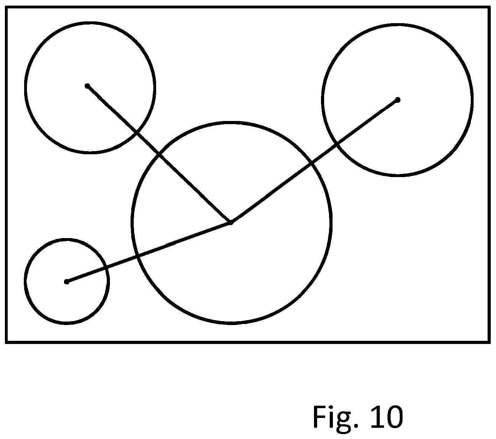

Ein mögliches Verfahren des Floorplannings mit kreisbasiertem Platzierungsansatz ist in Figur 10 gezeigt und besteht aus den Schritten:
1. Die Komponenten werden zunächst durch Kreise repräsentiert.
2. Die Fläche eines Kreises ist proportional zum Ressourcenbedarf der Komponente.
3. Die Kreismittelpunkte liegen ggf. nah ihrer benötigten Ressourcen, falls diese heterogen verteilt sind. Sie bilden die Ausgangspunkte der Komponenten.
4. Die Entfernungen der Kreismittelpunkte zueinander seien möglichst proportional zur Beziehung der Komponenten untereinander.
5. Die Kreise sind innerhalb eines Rechtecks anzuordnen, das die FPGA Fläche repräsentiert.

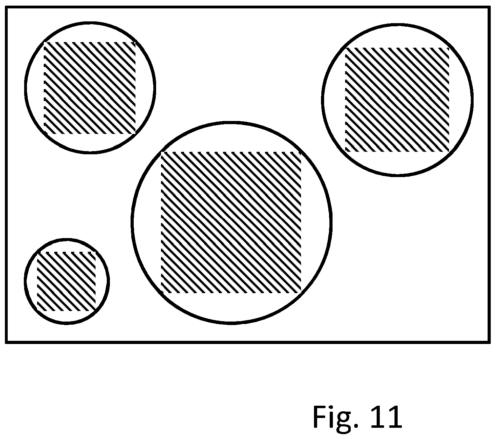

Die initialen Komponenten werden als Rechtecke der benötigten Größe auf ihren Ausgangspunkten platziert. Dies ist in Figur 11 gezeigt.

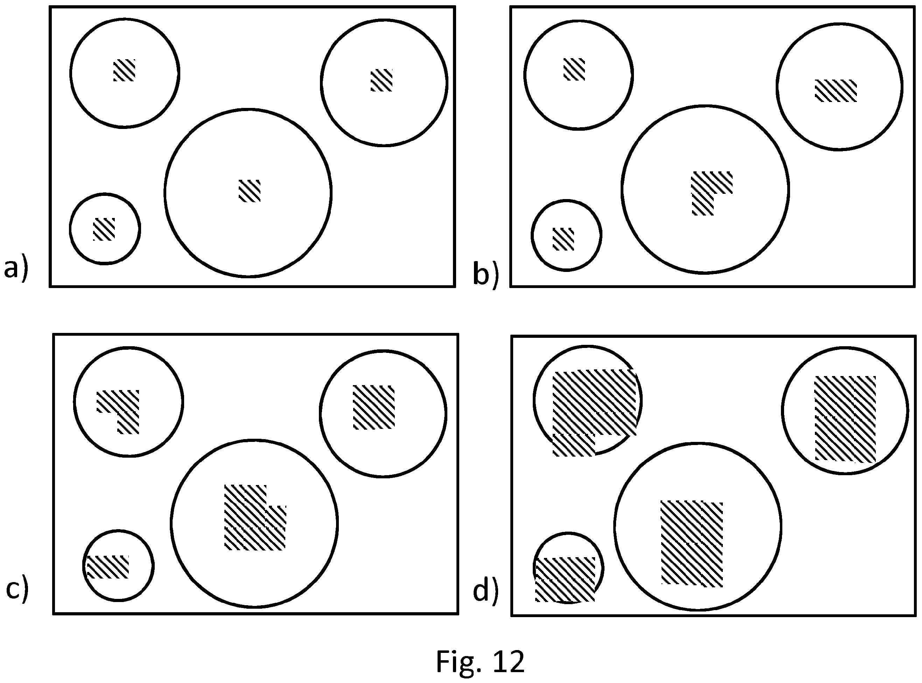

Beim "Region Growing" Ansatz wachsen die Komponenten ausgehend vom Ausgangspunkt iterativ gemäß ihrer Randbedingungen, bis eine geeignete rechteckige Größe erreicht wurde. Falls vom Designtool zugelassen, bieten Komponenten aus Rechteckverbünden hier enormes Potential. Ein Beispiel für eine Platzierung nach dem Region Growing Ansatz ist in Figur 12 gezeigt.

In Teil a) von Figur 12 ist dargestellt, dass zunächst jeweils das dem jeweiligen Kreismittelpunkt am nächsten liegende Rechteck reserviert wird. In den Teilen b), c) und d) von Figur 12 ist dargestellt, wie iterativ an den reservierten Bereich angrenzende Rechtecke reserviert werden, bis die reservierte Fläche groß genug ist für die zugeordnete Komponente.

## Patentansprüche

1. Verfahren zur Erstellung einer Netzliste eines FPGA-Programms, wobei das zugrundeliegende Modell des FPGA-Programms aus mindestens zwei Komponenten besteht, wobei jeder Komponente eine separate Partition auf dem FPGA zugeordnet wird, wobei für jede Komponente ein eigenständiger Build einer Netzliste durchgeführt wird, wobei aus den Netzlisten der Komponenten ein Gesamtstand erzeugt wird,
**dadurch gekennzeichnet, dass** das Modell des FPGA-Programms automatisiert in eine Vielzahl von kleineren Komponenten unterteilt wird, wobei bei Änderungen an einer einzelnen Komponente lediglich diese einzelne Komponente erneut synthetisiert, platziert und geroutet, sowie mit den bereits fertigen Netzlisten von Komponenten des FPGA-Programms zusammengefügt wird, wobei wenn bereits ein Gesamtstand vorliegt, bei einer Änderung an einer Komponente, beim Build eines neuen Gesamtstandes die geänderte Komponente im Gesamtstand nur dann aktualisiert wird, falls durch automatischen Vergleich mit allen versionierten Ständen der Komponente festgestellt wird, dass der aktuelle Stand der Komponente nicht einem zuvor versionierten Stand entspricht, wobei die Build Jobs automatisiert nach einem Triggerereignis gestartet werden, wobei das Triggerereignis ein Abspeichern einer Komponente, das Verlassen einer Komponente des Modells oder ein zeitgesteuertes, automatisiertes Anstoßen eines Builds ist, die fertig gebuildeten Komponenten automatisch versioniert werden, wobei automatisch ein Gesamtstand gebuildet wird, sobald alle Komponenten des Modells in einer gebuildeten Form vorliegen, wobei wenn bereits ein versionierter Stand der Komponente vorliegt, der versionierte Stand der Komponente verwendet wird.

2. Verfahren nach einem der vorhergehenden Ansprüche, **dadurch gekennzeichnet, dass** das FPGA automatisiert in eine Anzahl von Partitionen aufgeteilt wird, die der Anzahl der Komponenten des Modells des FPGA-Programms entspricht.

3. Verfahren nach einem der vorhergehenden Ansprüche, **dadurch gekennzeichnet, dass** die Komponenten automatisiert den Partitionen zugewiesen werden.

4. Verfahren nach einem der vorhergehenden Ansprüche, **dadurch gekennzeichnet, dass** eine erste Partition verkleinert und ein von der gebuildeten Form der Komponente, die der ersten Partition zugewiesenen ist, nicht benötigter Anteil einer zweiten Partition zugeordnet wird.

5. Verfahren nach einem der vorhergehenden Ansprüche, **dadurch gekennzeichnet, dass** eine dritte Partition und eine vierte Partition zu einer fünften Partition zusammengelegt werden und die der dritten Partition und der vierten Partition zugeordneten Komponenten zusammengefügt werden.

6. Verfahren nach einem der vorhergehenden Ansprüche, **dadurch gekennzeichnet, dass** die fertig gebuildeten Gesamtstände automatisiert versioniert werden.

7. Verfahren nach einem der vorhergehenden Ansprüche, **dadurch gekennzeichnet, dass** die Build Jobs von einem Job Queuer verwaltet werden.

8. Verfahren nach einem der vorhergehenden Ansprüche, **dadurch gekennzeichnet, dass** aus den Netzlisten der Komponenten und/oder aus einer Netzliste eines Gesamtstandes ein Bitstrom zur Konfiguration des FPGAs erzeugt wird.

9. Entwicklungsumgebung für eine Netzliste eines FPGA-Programms, **dadurch gekennzeichnet, dass** es ein Verfahren nach einem der vorhergehenden Ansprüche automatisiert durchführt.

## Claims

1. A method for creating a network list of an FPGA program, the underlying model of the FPGA program being made of at least two components, each component being associated with a separate partition on the FPGA, an independent build of a network list being performed for each component, an overall status being generated from the network lists of the components,
**characterized in that** the model of the FPGA program is automatically subdivided into a plurality of smaller components, wherein
for changes to a single component, only said single component is synthesized, placed, and routed again, and is merged with the already finished network lists of components of the FPGA program, wherein if an overall status is already present, for a change to a component, the modified component is not updated in the overall status when building a new overall status unless it is determined by automatically comparing with all version-controlled statuses of the component that the current status of the component does not correspond to a previously version-controlled status, wherein
the build jobs are automatically started after a trigger event, wherein the trigger event is saving a component, exiting a component of the model, or a time-regulated, automated initiating of a build,
the finished components are automatically version-controlled, wherein an overall status is automatically built as soon as all components of the model are present in a built form, wherein
if a version-controlled status of the component is already present, then the version-controlled status of the component is used.

2. The method according to any one of the preceding claims, **characterized in that** the FPGA is automatically subdivided into a quantity of partitions corresponding to the quantity of components of the model of the FPGA program.

3. The method according to any one of the preceding claims, **characterized in that** the components are automatically associated with the partitions.

4. The method according to any one of the preceding claims, **characterized in that** a first partition is shrunk and a portion unneeded by the built form of the component associated with the first partition is associated with a second partition.

5. The method according to any one of the preceding claims, **characterized in that** a third partition and a fourth partition are merged into a fifth partition and the components associated with the third partition and the fourth partition are merged.

6. The method according to any one of the preceding claims, **characterized in that** the finished overall statuses are automatically version-controlled.

7. The method according to any one of the preceding claims, **characterized in that** the build jobs are administered by a job queuer.

8. The method according to any one of the preceding claims, **characterized in that** a bitstream for configuring the FPGA is generated from the network lists of the components and/or from a network list of an overall status.

9. A development environment for a network list of an FPGA program, **characterized in that** said program automatically performs a method according to any one of the preceding claims.

## Revendications

1. Procédé pour créer une liste d'interconnexions d'un programme FPGA, dans lequel le modèle sous-jacent du programme FPGA est constitué d'au moins deux composants, dans lequel une partition séparée sur le FPGA est attribuée à chaque composant, dans lequel un numéro de compilation indépendant d'une liste d'interconnexions est réalisé pour chaque composant, dans lequel un état global est généré à partir des listes d'interconnexions des composants,
**caractérisé en ce que** le modèle du programme FPGA est divisé de manière automatisée en une pluralité de composants plus petits, dans lequel,
en cas de modifications sur un composant individuel, seul ce composant individuel est synthétisé, placé et acheminé à nouveau, et est combiné avec les listes d'interconnexions déjà achevées de composants du programme FPGA, dans lequel, si un état global existe déjà, en cas de modification sur un composant, lors de la compilation d'un nouvel état global, le composant modifié n'est mis à jour dans l'état global que s'il est déterminé par comparaison automatique avec tous les états versionnés du composant que l'état actuel du composant ne correspond pas à un état versionné précédemment, dans lequel
les travaux de compilation sont lancés automatiquement après un événement déclencheur, dans lequel l'événement déclencheur est une mémorisation d'un composant, la sortie d'un composant du modèle ou un déclenchement d'une compilation automatisé et asservi au temps,
dans lequel les composants dont la compilation est achevée sont versionnés automatiquement, sachant qu'un état global est compilé automatiquement aussitôt que tous les composants du modèle existent sous forme compilée, dans lequel
s'il existe déjà un état versionné du composant, l'état versionné du composant est utilisé.

2. Procédé selon l'une quelconque des revendications précédentes, **caractérisé en ce que** le FPGA est automatiquement divisé en un nombre de partitions qui correspond au nombre de composants du modèle du programme FPGA.

3. Procédé selon l'une quelconque des revendications précédentes, **caractérisé en ce que** les composants sont automatiquement attribués aux partitions.

4. Procédé selon l'une quelconque des revendications précédentes, **caractérisé en ce qu'**une première partition est réduite et une partie qui n'est pas requise par la forme compilée du composant attribué à la première partition est attribuée à une deuxième partition.

5. Procédé selon l'une quelconque des revendications précédentes, **caractérisé en ce qu'**une troisième partition et une quatrième partition sont fusionnées en une cinquième partition, et les composants attribués à la troisième partition et à la quatrième partition sont fusionnés.

6. Procédé selon l'une quelconque des revendications précédentes, **caractérisé en ce que** les états globaux dont la compilation est achevée sont automatiquement versionnés.

7. Procédé selon l'une quelconque des revendications précédentes, **caractérisé en ce que** les travaux de compilation sont gérés par un Job Queuer de mise en file d'attente des travaux.

8. Procédé selon l'une quelconque des revendications précédentes, **caractérisé en ce qu'**un train de bits pour la configuration du FPGA est généré à partir des listes d'interconnexions des composants et/ou à partir d'une liste d'interconnexions d'un état global.

9. Environnement de développement pour une liste d'interconnexions d'un programme FPGA, **caractérisé en ce qu'**il exécute automatiquement un procédé selon l'une quelconque des revendications précédentes.
